# EUROPEAN PATENT APPLICATION

(11) **EP 4 585 947 A1**
(43) Date of publication of application: **16.07.2025**
(21) Application number: 23939338.2
(22) Date of filing: 07.12.2023
(51) Int. Cl.: G01R 31/385, G01R 31/387, G01R 31/367

(54) **BATTERY SELF-DISCHARGE CURRENT SENSING METHOD, BATTERY SELF-DISCHARGE CAPACITY PREDICTION METHOD, BATTERY SELF-DISCHARGE SCREENING METHOD, DEVICE AND MEDIUM**

(30) Priority: 29.05.2023 CN 202310642378
(71) Applicant: Eve Power Co., Ltd., Jingmen, Hubei 448000 (CN)
(72) Inventor: LI, Xia, Jingmen, Hubei 448000 (CN); DAI, Li, Jingmen, Hubei 448000 (CN); SU, Bin, Jingmen, Hubei 448000 (CN); CHEN, Liquan, Jingmen, Hubei 448000 (CN)
(74) Representative: Herrero & Asociados, S.L.
(86) International application number: PCT/CN2023/137241
(87) International publication number: WO 2024/244369

(57) **Abstract**

The present disclosure discloses a current detection method, a capacity prediction method, and a screening method for battery self-discharge, a device and a medium. In the current detection method for battery self-discharge, a battery is charged with a tiny current by a regulated power supply under a preset condition. During a charging process, a charging current provided by the regulated power supply is adjusted until a voltage of the battery remains stable. When the voltage of the battery to be tested remains stable, the charging current is determined as a self-discharge current of the battery under the preset condition.

## Description

The present disclosure claims priority to Chinese Patent Application No. 202310642378.0, filed with the Chinese Patent Office on May 29, 2023, the disclosure of which is incorporated herein by reference in its entirety.

### TECHNICAL FIELD

The present disclosure relates to the technical field of batteries, and for example, to a current detection method, a capacity prediction method, a screening method for battery self-discharge, a device, and a medium.

### BACKGROUND

The purpose of self-discharge detection is to obtain the self-discharge degree of lithium-ion batteries, and select batteries with excessive self-discharge, thereby preventing unqualified batteries from being delivered to customers.

In the related technologies, there are two self-discharge detection methods for lithium-ion batteries commonly used in industrial-scale production: a voltage drop method and a capacity detection method. The voltage drop method is to detect an open circuit voltage of a lithium-ion battery before and after the lithium-ion battery is left stationary, thereby obtaining a self-discharge voltage drop. This method is simple and low in cost. The capacity detection method is to detect capacity values of self-discharge before and after the lithium-ion battery is left stationary, thereby obtaining a self-discharge loss capacity. This method has high accuracy.

However, the voltage drop method has poor detection accuracy, while the capacity detection method has a long detection time.

### TECHNICAL PROBLEM

The present disclosure provides a current detection method, a capacity prediction method, a screening method, a device and a medium for battery self-discharge, so as to shorten the detection time and improve the detection accuracy.

### TECHNICAL SOLUTION

According to a first aspect, the embodiments of the present disclosure provide a current detection method for battery self-discharge. The current detection method for battery self-discharge includes:
charging, under a preset condition, a battery by using a regulated power supply;
adjusting, during a charging process, a charging current provided by the regulated power supply until a voltage of the battery remains stable;
when the voltage of the battery remains stable, determining the charging current as a self-discharge current of the battery under the preset condition.

According to a second aspect, the embodiments of the present disclosure further provide a loss capacity prediction method for battery self-discharge. The loss capacity prediction method for battery self-discharge includes:
obtaining experimental data of an experimental battery in a self-discharge current detection by using any of the current detection methods for battery self-discharge of the first aspect;
determining, based on an Arrhenius formula combined with the experimental data, a first relational expression of a self-discharge loss capacity of a battery to be tested and static condition data; where a material system of the battery to be tested is consistent with that of the experimental battery;
recording, during a storage process of the battery to be tested, measured values of static condition data of the battery to be tested; and
predicting, based on the measured values of the static condition data and the first relational expression, a current self-discharge loss capacity and a current remaining capacity of the battery to be tested.

According to a third aspect, the embodiments of the present disclosure further provide a screening method for battery self-discharge. The screening method for battery self-discharge includes:
determining self-discharge currents of batteries to be tested under a preset condition by using any of the current detection methods for battery self-discharge of the first aspect;
performing, according to a relative relationship between the self-discharge current and a self-discharge current threshold value under the preset condition, a first screening on the batteries to be tested, to screen out first qualified batteries with normal self-discharge;
during a storage process of the first qualified batteries, predicting current remaining capacities of the first qualified batteries by using any of the loss capacity prediction methods for self-discharge of the second aspect; and
at an end of the storage process, performing, according to a relative relationship between the remaining capacity and a standard capacity for cell matching, a second screening on the first qualified batteries, to screen out a second qualified battery of which the remaining capacity satisfies cell matching requirements.

According to a fourth aspect, the embodiments of the present disclosure further provide an electronic device. The electronic device includes:
at least one processor;
a memory communicatively coupled to the at least one processor; where,
the memory stores a computer program executable by the at least one processor, where the computer program, when executed by the at least one processor, cause the at least one processor to perform the method according to any one of the first aspect, the second aspect, and the third aspect.

According to a fifth aspect, the embodiments of the present disclosure further provide a computer readable storage medium. The computer readable storage medium stores computer instructions, and the computer instructions, when executed by a processor, are configured to implement the method according to any one of the first aspect, the second aspect, and the third aspect.

### BENEFICIAL EFFECTS

Beneficial effects of the present disclosure: the current detection method, the capacity prediction method, the screening method for battery self-discharge, the device, and the medium, a battery is charged with a tiny current by a regulated power supply under a preset condition. During a charging process, the charging current provided by the regulated power supply is adjusted until the voltage of the battery remains stable. When the voltage of the battery to be tested remains stable, the charging current is determined as the self-discharge current of the battery under the preset condition, thereby realizing current detection for battery self-discharging. Traditional voltage detection needs to take 3 to 7 days of time. The detection method provided by this embodiment can typically confine the current detection of self-discharge to within one day, shortening the detection time. This method also improves the accuracy of detection based on the fundamental principles of self-discharge.

### BRIEF DESCRIPTION OF THE DRAWINGS

FIG. 1 is a schematic flowchart of a current detection method for battery self-discharge provided by embodiments of the present disclosure;
FIG. 2 is a schematic diagram of a composition of a current detection device for battery self-discharge provided by embodiments of the present disclosure;
FIG. 3 is a schematic flowchart of a loss capacity prediction method for battery self-discharge provided by embodiments of the present disclosure;
FIG. 4 is a schematic flowchart of another loss capacity prediction method for battery self-discharge provided by embodiments of the present disclosure;
FIG. 5 is a graph of a relationship between self-discharge current and static duration of a lithium iron phosphate battery at 25°C provided by embodiments of the present disclosure;
FIG. 6 is a graph of a relationship between self-discharge currents and static temperatures of a lithium iron phosphate battery provided by embodiments of the present disclosure in a case in which a static duration is determined;
FIG. 7 is a schematic diagram of a relationship between logarithms of self-discharge currents and inverses of static temperatures of a lithium iron phosphate battery provided by embodiments of the present disclosure;
FIG. 8 is a schematic flowchart of a screening method for battery self-discharge provided by embodiments of the present disclosure;
FIG. 9 is a schematic diagram of a composition of an electronic device provided by embodiments of the present disclosure.

### DETAILED DESCRIPTION

As described in the background art, there are two self-discharge detection methods for lithium-ion batteries commonly used in industrial-scale production: a voltage drop method and a capacity detection method. The voltage drop method is to detect an open circuit voltage of a lithium-ion battery before and after the lithium-ion battery is left stationary, thereby obtaining a self-discharge voltage drop. This method is simple and low in cost. The capacity detection method is to detect capacity values of self-discharge before and after the lithium-ion battery is left stationary, thereby obtaining a self-discharge loss capacity. This method has high accuracy. The battery self-discharge detection is to evaluate the self-discharge degree of each battery during a production process, so as to pick out defective products and prevent unqualified batteries from being delivered to customers. However, the voltage drop method has poor detection accuracy, while the capacity detection method has a long detection time and consumes a lot of energy. In conclusion, the two methods are not ideal when actually used for battery self-discharge screening.

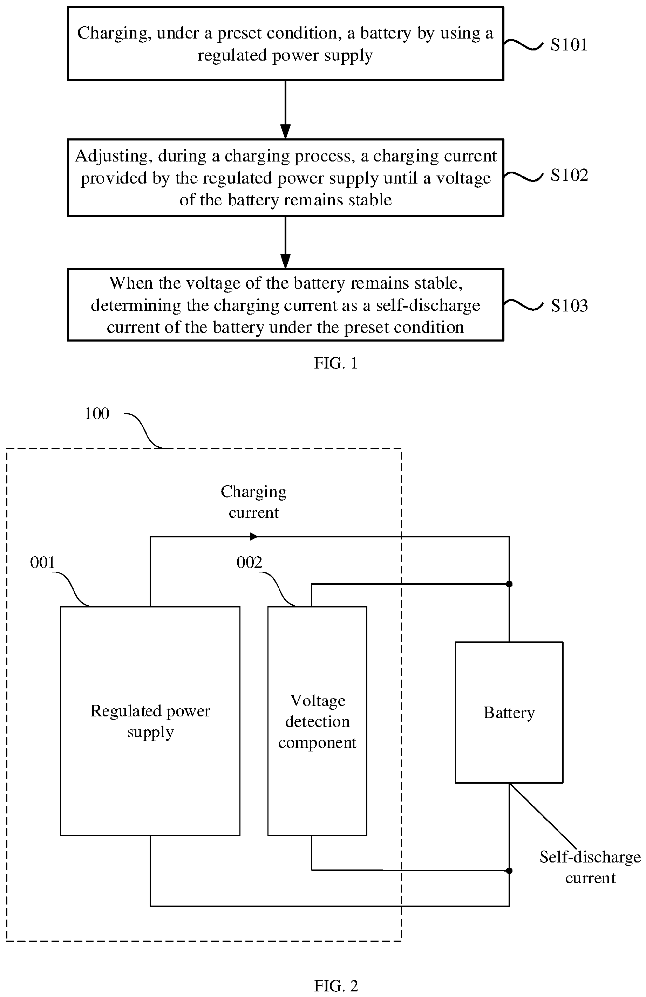

In order to solve the aforementioned problem, embodiments of the present disclosure provide a current detection method for battery self-discharge. FIG. 1 is a schematic flowchart of a current detection method for battery self-discharge provided by embodiments of the present disclosure. FIG. 2 is a schematic diagram of a composition of a current detection device for battery self-discharge provided by embodiments of the present disclosure. Combining FIG. 1 and FIG. 2, the current detection method for battery self-discharge includes:

S101, charging, under a preset condition, a battery by using a regulated power supply.

Specifically, the current detection device 100 for battery self-discharge includes a regulated power supply 001. The regulated power supply 001 refers to a power supply capable of stabilizing an output voltage, and compensating an amplitude of the output voltage to keep the output voltage of the regulated power supply stable. The preset condition refers to detection conditions of the battery during a current detection process for self-discharge of the battery, and may include a preset static duration and/or a preset static temperature of the battery. Detection results of the battery vary under different preset conditions. The preset condition can be preset according to detection requirements. For example, if it is necessary to know the self-discharge current of the battery after standing at room temperature (25°C) for 20 hours, the preset static temperature in the preset condition can be set to room temperature (25°C), and the preset static duration can be set to 20 hours. Under the preset condition, the regulated power supply is used to supply a tiny current to continuously charge the battery. Before using the regulated power supply to charge the battery, since self-discharge is an inherent property of the battery, the capacity of the battery will continue to decay with the static duration, and the voltage of the battery will gradually decrease as well. When the regulated power supply outputs a tiny current to continuously charge the battery, the capacity of the battery is slightly supplemented, and the voltage can be slightly increased or the speed of voltage decrease is reduced.

S102, adjusting, during a charging process, a charging current provided by the regulated power supply until a voltage of the battery remains stable.

Specifically, the current detection device 100 for battery self-discharge further includes a voltage detection component 002, which can detect the voltage across the battery. When the regulated power supply is used to charge the battery, an initially set charging current may not be equal to a self-discharge current of the battery, therefore, current adjustment of the regulated power supply needs to be performed level by level, so that the charging current output by the regulated power supply is equal to the self-discharge current of the battery. The criterion for determining whether the charging current is equal to the self-discharge current of the battery may be that the battery voltage remains stable during the charging process by using the charging current. The adjustment may include gradually increasing or decreasing the charging current according to a change trend of the voltage of the battery, and then changing an adjustment direction (decreasing or increasing) after the change trend of the battery voltage changes, until the battery voltage remains stable.

For example, before charging, if the voltage detection component detects that a decreasing change trend in battery voltage and the regulated power supply is used to charge the battery, the change trend of the battery voltage becomes increasing, and at this time, a charging current provided by the regulated power supply is gradually decreased until the change trend of the battery voltage become stable or decreased. If it remains stable, this step is finished. If it becomes decreasing, an adjustment direction of the charging current provided by the regulated power supply is changed to gradually increase. In this way, this cycles repeats until the battery voltage remains stable after the charging current provided by the regulated power supply is adjusted. At this time, the self-discharge current of the battery is equal to the charging current provided by the regulated power supply.

S103, when the voltage of the battery remains stable, determining the charging current as a self-discharge current of the battery under the preset condition.

Specifically, in the process of charging the battery by using the regulated power supply, after the charging current is adjusted, if the voltage of the battery does not change with time, it indicates that the loss capacity of the battery self-discharge is the same as the capacity input by the regulated power supply for the battery, and at this time, the charging current output by the regulated power supply is equal to the self-discharge current of the battery, and the output charging current of the regulated power supply is recorded as the self-discharge current of the battery under the preset condition.

In the current detection method for battery self-discharge provided by the present embodiments, a battery is charged with a tiny current by a regulated power supply under a preset condition. During a charging process, the charging current provided by the regulated power supply is adjusted until the voltage of the battery remains stable. When the voltage of the battery to be tested remains stable, the charging current is determined as the self-discharge current of the battery under the preset condition, thereby realizing current detection for battery self-discharging. Traditional voltage detection needs to take 3 to 7 days of time. The detection method provided by this embodiment can typically confine the current detection of self-discharge to within one day, shortening the detection time. This method also improves the accuracy of detection based on the fundamental principles of self-discharge.

Based on the aforementioned related technologies and embodiments, the inventors further discovered that there is a long time difference between the time when qualified batteries are offline after self-discharge screening is completed to the time when they are used by clients. The time difference is generally 1 to 6 months or even longer. However, due to different batteries have differences in self-discharge degree consistency, in addition to the influence of storage time, after long-term storage, the self-discharge degree of batteries that did not show obvious self-discharge in the early self-discharge screening becomes prominent. If these batteries with high self-discharge degree are used in cell matching by users, the performance of the entire battery module will be affected, thereby causing economic losses to users.

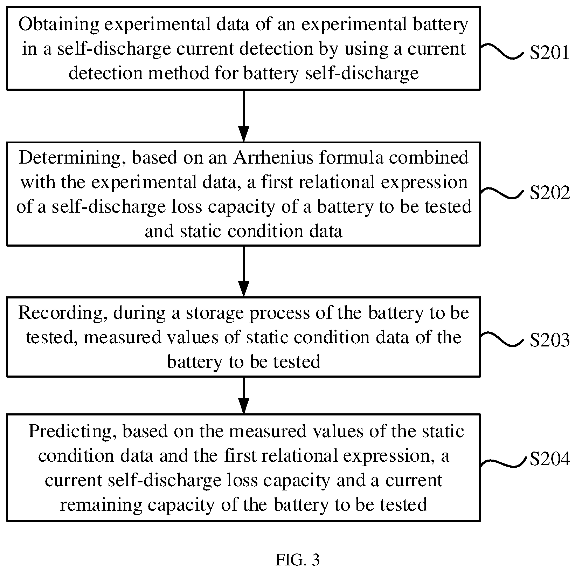

Based on this, embodiments of the present disclosure further provide a loss capacity prediction method for battery self-discharge. FIG. 3 is a schematic flowchart of a loss capacity prediction method for battery self-discharge provided by the embodiments of the present disclosure. Referring to FIG. 3, the loss capacity prediction method for battery self-discharge includes:
S201, obtaining experimental data of an experimental battery in a self-discharge current detection by using a current detection method for battery self-discharge.

Specifically, the experimental battery refers to a battery used for experiments, a material system of which is consistent with that of the battery to be tested. A series of experiments can be performed by using the experimental battery to obtain state parameters of the battery to be tested under different experimental conditions. Self-discharge current detection refers to an experimental operation of performing self-discharge current detection on an experimental battery under different preset conditions. A relationship between the self-discharge current of the experimental battery and each preset condition can be obtained by means of self-discharge current detection. The experimental data refers to the data recorded in the self-discharge current detection, which may include the preset condition and a self-discharge current of the battery corresponding to the preset condition.

S202, determining, based on an Arrhenius formula combined with the experimental data, a first relational expression of a self-discharge loss capacity of a battery to be tested and static condition data.

Specifically, the static condition data refers to condition data of the battery to be tested during a storage process, which is equivalent to the preset condition in an experimental process. For example, the static condition data may include a static duration and a static temperature. A material system of the battery to be tested is consistent with that of the experimental battery. A reaction rate of self-discharge of lithium-ion batteries conforms to the Arrhenius formula: *k = Ae*^{*-*(*Ea*/*RT*)}, where k is a self-discharge reaction rate constant; Ea is a reaction activation energy of the battery to be tested; R is an ideal gas constant; T is a reaction temperature, and its unit is K; A is a pre-exponential factor, which refers to other factors, other than the temperature, the activation energy and the ideal gas constant, that affect the self-discharge rate constant. On the basis of the Arrhenius formula and in combination with the experimental data of the experimental battery in the self-discharge current detection, the first relational expression of the self-discharge loss capacity of the battery to be tested and the static condition data can be determined. The experimental data may include multiple groups of static condition data (equivalent to the preset condition in S201) and the self-discharge currents of the experimental battery under different static condition data, which can help to determine a relative relationship between the self-discharge current and each static condition data, and then further determine a relative relationship between the self-discharge loss capacity and each static condition data. After understanding the relationship between the self-discharge current and the self-discharge reaction rate constant, as well as the relationship between the self-discharge current and the self-discharge loss capacity, the first relational expression of the self-discharge loss capacity of the battery to be tested and the static condition data can be determined based on the Arrhenius formula. The first relational expression is a variant of the Arrhenius formula, and can represent the relationship between the self-discharge loss capacity of the battery to be tested and each static condition data. For example, the experimental data may include a fixed static duration, multiple groups of static temperatures, and battery self-discharge currents corresponding to different combinations of duration and temperature. The experimental data may also include multiple groups of static duration, a fixed static temperature, and battery self-discharge currents corresponding to different combinations of duration and temperature.

S203, recording, during a storage process of the battery to be tested, measured values of static condition data of the battery to be tested.

Specifically, the static condition data during the storage process is equivalent to the preset condition in the current detection method for battery self-discharge. During the storage process, the measured values of the static condition data of the battery to be tested may be recorded once every preset time period, or the measured values of the static condition data of the battery to be tested may be recorded in real time. For example, the static condition data may include a static duration and a static temperature. The static duration may be recorded by recording a difference value between a real time and a time for starting storage, and the static temperature may be collected by a temperature sensor.

S204, predicting, based on the measured values of the static condition data and the first relational expression, a current self-discharge loss capacity and a current remaining capacity of the battery to be tested.

Specifically, the first relational expression can represent a relationship between the self-discharge loss capacity of the battery to be tested and each static condition data. After recording the measured value of the static condition data in the storage process, the measured value of the static condition data can be substituted into the first relational expression to predict the current self-discharge loss capacity of the battery to be tested. The remaining capacity of the battery to be tested can be determined according to a difference value between an initial capacity and the self-discharge loss capacity of the battery.

The loss capacity prediction method for battery self-discharge provided by the embodiments uses the current detection method for battery self-discharge to obtain the experimental data of the experimental battery in self-discharge current detection; determines, based on the Arrhenius formula combined with the experimental data, the first relational expression of the self-discharge loss capacity of the battery to be tested and the static condition data; records the static condition data of the battery to be tested during a storage process of the battery to be tested; and predicts, based on the static condition data and the first relational expression, a current self-discharge loss capacity and a remaining capacity of the battery to be tested, thereby realizing the prediction of the self-discharge loss capacity of the battery to be tested. After an accumulation of experimental data in an early stage and a derivation of the relational expression, only the static condition data during the storage process needs to be collected when making the prediction, so that the self-discharge loss capacity of the battery only needs to be predicted, and this method is simple and has high accuracy.

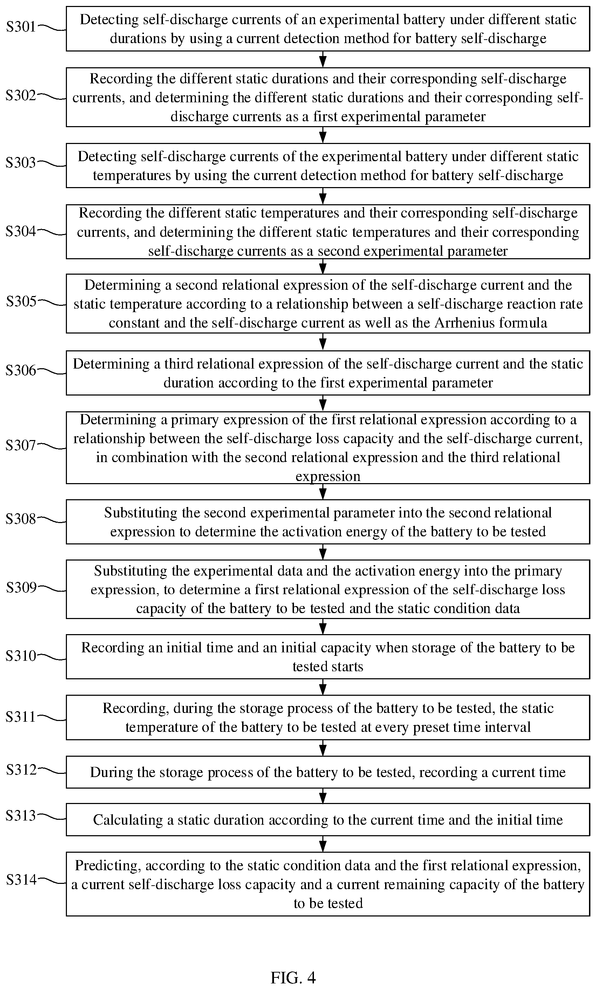

FIG. 4 is a schematic flowchart of another loss capacity prediction method for battery self-discharge provided by embodiments of the present disclosure. Referring to FIG. 4, the loss capacity prediction method for battery self-discharge includes:

S301, detecting self-discharge currents of an experimental battery under different static durations by using a current detection method for battery self-discharge.

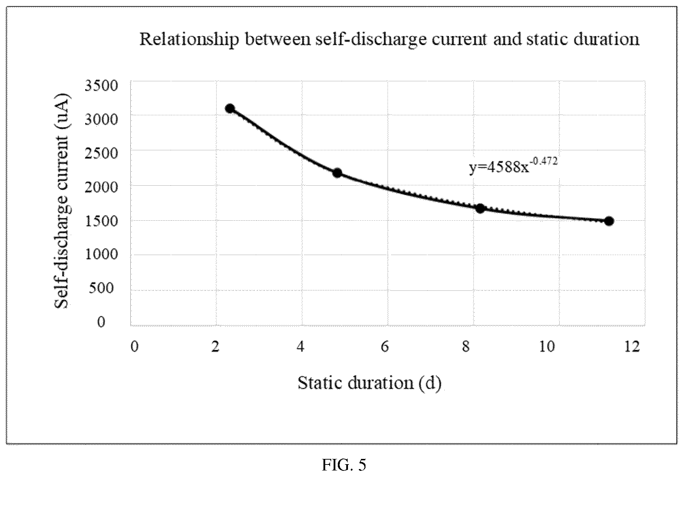

Specifically, the static temperature of the preset condition in the current detection method for battery self-discharge is set to a uniform value, and the current detection method for battery self-discharge is used to detect the self-discharge current of the experimental battery under different static durations. FIG. 5 is a graph of a relationship between the self-discharge current and the static duration of a lithium iron phosphate battery at 25°C provided by the embodiments of the present disclosure. Combined with FIG. 5, the self-discharge current of the experimental battery decreases with the increase of the static duration. The relational expression in the figure is a relational expression of the self-discharge current with respect to the static duration which is fitted according to the experimental data in a case where the static temperature is a fixed value, where y is a longitudinal coordinate of the relationship curve, and x is a horizontal coordinate of the relationship curve.

S302, recording the different static durations and their corresponding self-discharge currents, and determining the different static durations and their corresponding self-discharge currents as a first experimental parameter.

Specifically, the experimental data includes the first experimental parameter. The first experimental parameter includes different static durations and their corresponding self-discharge currents. In an experiment of detecting an experimental battery using the current detection method for recording battery self-discharge, the self-discharge currents of the experimental battery under different static durations are recorded and taken as the first experimental parameter.

S303, detecting self-discharge currents of the experimental battery under different static temperatures by using the current detection method for battery self-discharge.

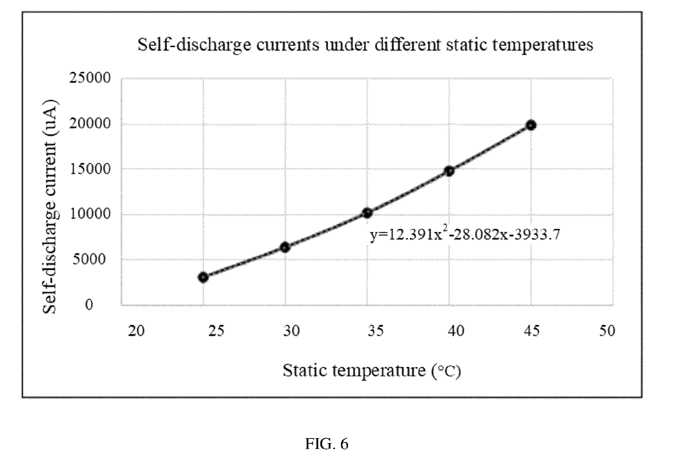

Specifically, the static duration of the preset condition in the current detection method for battery self-discharge is set to a uniform value, and the current detection method for battery self-discharge is used to detect the self-discharge current of the experimental battery under different static temperatures. FIG. 6 is a graph of a relationship between the self discharge currents and the static temperatures of a lithium iron phosphate battery provided by embodiments of the present disclosure in a case in which a static duration is determined. Combined with FIG. 6, the self-discharge current of the experimental battery increases with the increase of the static temperature. The relational expression in the figure is a relational expression of the self-discharge current with respect to the static temperature which is fitted according to experimental data in a case where the static duration is a fixed value, where y is a longitudinal coordinate of the relationship curve, and x is a horizontal coordinate of the relationship curve.

S304, recording the different static temperatures and their corresponding self-discharge currents, and determining the different static temperatures and their corresponding self-discharge currents as a second experimental parameter.

Specifically, the experimental data includes the second experimental parameter. The second experimental parameter includes different static temperatures and their corresponding self-discharge currents. In an experiment of detecting an experimental battery using the current detection method for recording battery self-discharge, the self-discharge currents of the experimental battery under different static temperatures are recorded and taken as the second experimental parameter.

S305, determining a second relational expression of the self-discharge current and the static temperature according to a relationship between a self-discharge reaction rate constant and the self-discharge current as well as the Arrhenius formula.

Specifically, the self-discharge reaction rate of a lithium-ion battery conforms to the Arrhenius formula *k = Ae*^{*-*(*Ea*/*RT*)}, where k is a self-discharge reaction rate constant; Ea is a reaction activation energy of the self-discharge reaction of the battery; R is an ideal gas constant; T is a reaction temperature, and its unit is K; A is a pre-exponential factor. However, the physical quantity of the reaction rate constant k is relatively difficult to obtain through experiments. The present patent adopts the described current detection method for battery self-discharge to detect the self-discharge current. In a case where other influencing factors remain unchanged, the self-discharge reaction rate constant has a positive correlation with the self-discharge current. Therefore, when determining the second relational expression of the self-discharge current and the static temperature, the pre-exponential factor can be changed to determine the second relational expression to represent a relationship between the self-discharge current and the temperature. The second relational expression is *I = Be*^{*-*(*Ea*/*RT*)}, where I is the self-discharge current; B is a pre-exponential factor of the second relational expression, which refers to other influence factors, other than the temperature, the activation energy and the ideal gas constant, that affect the self-discharge current .

S306, determining a third relational expression of the self-discharge current and the static duration according to the first experimental parameter.

Specifically, the first experimental parameter includes different static durations and their corresponding self-discharge currents. Continue to refer to FIG. 5, under thermostatic conditions, the relationship between the self-discharge current and the static duration is expressed as the third relational expression: *I = Ctⁿ,* where I is a self-discharge current; C is a pre-expression factor of the third relational expression, which refers to other factors, other than the static duration, that affect the self-discharge current; n is a power coefficient; and t is a static duration. By using the current detection method of battery self-discharge to conduct experiments, a large amount of data as shown in the data points of FIG. 5 can be obtained. Substituting these data into the third relational expression, it can be determined that n is approximately equal to -0.5. Thus, the third relational expression is *I = Ct*^{*-*0.5}. For example, the present patent takes lithium iron phosphate as an example of a system, the relationship between the self-discharge current and the static duration at 25°C is as shown in FIG. 5, which is consistent with the relationship between the self-discharge current and the static duration in the third relational expression.

S307, determining a primary expression of the first relational expression according to a relationship between the self-discharge loss capacity and the self-discharge current, in combination with the second relational expression and the third relational expression.

Specifically, the relationship between the self-discharge loss capacity and the self-discharge current can be expressed by a fourth relational expression: *Q_{self}* = *It,* where Q_{self} is the self-discharge loss capacity, I is the self-discharge current, and t is the static duration. Based on the fourth relational expression *Q_{self} = It,* combined with the second relational expression *I = Be*^{*-*(*Ea*/*RT*)} and the third relational expression *I = Ctⁿ,* a primary relational expression of the self-discharge loss capacity *Q_{self}* with respect to the static temperature T, the static duration t and the activation energy Ea can be obtained, i.e., the primary expression of the first relational expression, *Q_{self} = De*^{*-*(*Ea*/*RT*)}*t*^{0.5}, where D is a pre-expression factor of the first relational expression, which refers to other factors, other than the static duration, the static temperature, and the activation energy, that affect the self-discharge loss capacity.

S308, substituting the second experimental parameter into the second relational expression to determine the activation energy of the battery to be tested.

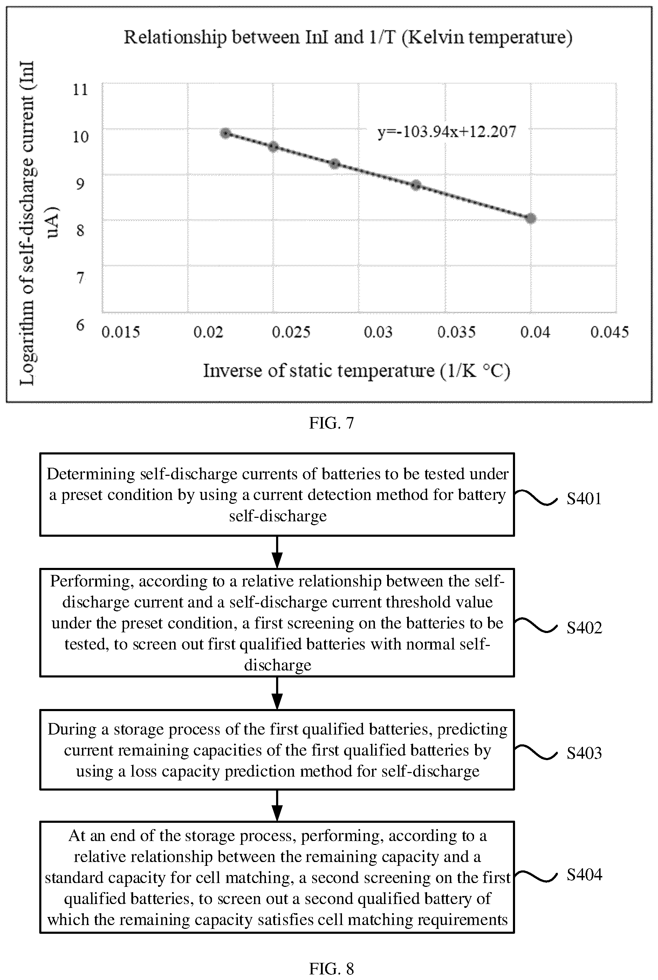

Specifically, the second experimental parameter includes different static temperatures and their corresponding self-discharge currents. The second relational expression *I = Be*^{-(*Ea*/*RT*)} may be logarithmically transformed to obtain a variant of the second relational expression: *InI = -Ea*/*RT + F,* where F is a pre-exponential factor. By substituting multiple groups of the second experimental parameters into the variant of the second relational expression after logarithmic transformed, the self-discharge reaction activation energy of a material system of the battery to be tested can be calculated. For example. FIG. 7 is a schematic diagram of a relationship between logarithms of the self-discharge currents and inverses of the static temperatures of a lithium iron phosphate battery provided by the embodiments of the present disclosure. Referring to FIG. 7, which shows a relationship curve plotted based on the variant of the second relational expression of the lithium iron phosphate battery. It can be seen from FIG. 7 that the logarithm of the self-discharge current is in a linear relationship with the activation energy, and the activation energy of the lithium iron phosphate battery can be calculated to be equal to 72057 KJ/mol.

S309, substituting the experimental data and the activation energy into the primary expression, to determine a first relational expression of the self-discharge loss capacity of the battery to be tested and the static condition data.

Specifically, firstly, the activation energy of the battery to be tested determined in step S308 is substituted into the primary expression of the first relational expression, and then multiple groups of experimental data are respectively substituted into the primary expression of the first relational expression, to determine an exact value of the pre-exponential factor D in the primary expression. At this time, the first relational expression representing the relationship between the self-discharge loss capacities of the battery to be tested and each static condition data is determined. For example, taking a lithium iron phosphate battery as an example, by substituting multiple groups of data points in FIG. 5 and FIG. 6 into the primary expression of the first relational expression respectively, it can be obtained that the value of the pre-exponential factor D is equal to 7.3, and then with regard to lithium iron phosphate, the first relational expression of the calculation formula of the self-discharge capacity under different temperatures and durations is *Q_{self} =* 7.3^{*e-*(72057/*RT*)}*t*^{0.5}.

S310, recording an initial time and an initial capacity when storage of the battery to be tested starts.

Specifically, the battery to be tested needs to be stored for a period of time after it is self-discharged and screened off a production line before it is used. At the beginning of the storage process, it is necessary to record an initial time and an initial capacity when the storage of the battery to be tested starts, where the initial time refers to the time when storage of the battery to be tested starts, and the initial capacity refers to the capacity of the battery to be tested when storage starts.

S311, recording, during the storage process of the battery to be tested, the static temperature of the battery to be tested at every preset time interval.

Specifically, the preset time interval refers to a time interval for collecting the static temperature of the battery to be tested, and the time interval may be determined according to requirements. For example, the preset time interval may be 6 hours.

S312, during the storage process of the battery to be tested, recording a current time.

S313, calculating a static duration according to the current time and the initial time.

Specifically, during the storage process of the battery to be tested, the current time can be recorded to obtain the static duration of the battery to be tested. Then, according to a difference value between the current time and the initial time, the static duration of the battery to be tested can be calculated, and a calculation formula is t=t₂-t₁,where t₁ is a time point at the start of storage, t₂ is a current time point, and t is the static duration.

S314, predicting, according to the static condition data and the first relational expression, a current self-discharge loss capacity and a current remaining capacity of the battery to be tested.

Specifically, the static duration and an average of the static temperatures of the battery to be tested can be obtained according to the static condition data. By substituting the static duration and the average of the static temperatures into the first relational expression, the current self-discharge loss capacity of the battery to be tested can be determined. The current remaining capacity of the battery to be tested is determined according to a difference value between the initial capacity when storage of the battery to be tested starts and the self-discharge loss capacity.

For example, the battery to be tested is a lithium iron phosphate battery. According to all the static temperatures during the storage process, an average static temperature during the storage process of the battery to be tested can be calculated, and a calculation formula is T_{avg}=(T₁+T₂+...+Tₘ)/m, where T_{avg} is the average static temperature; T₁, T₂, ..., Tₘ are respectively the static temperatures collected at various test moments, for example, the static temperatures can be collected every 6 to 12 hours on average; n is the number of times the static temperature is collected. By substituting the static duration and the average static temperature into the first relational expression *Q_{self}* = 7.3^{*e*-(72057/*RT*)}*t*^{0.5} of the lithium iron phosphate battery, the current self-discharge loss capacity of the battery to be tested can be determined. According to the difference value between the initial capacity of the battery to be tested at the beginning storage and the self-discharge loss capacity, the current remaining capacity of the battery to be tested is determined, and a calculation formula is Qᵣₑₘₐᵢₙ=Qᵢₙᵢₜᵢₐₗ-Qₗₒₛₛ, where Qᵢₙᵢₜᵢₐₗ is the capacity of the battery when it goes off a production line, which is also the capacity at the beginning of storage. Qₗₒₛₛ is the capacity lost from the battery to be tested going offline to cell matching (currently); and Qᵣₑₘₐᵢₙ is the remaining capacity of the battery to be tested.

In the loss capacity prediction method for battery self-discharge provided by the present embodiments, a first relational expression of self-discharge loss capacity of a battery to be tested and the static condition data can be determined based on the Arrhenius formula combined with the experimental data obtained by the current detection method for battery self-discharge, and then the static condition data of the battery to be tested can be recorded during the storage process of the battery to be tested. According to the static condition data and the first relational expression, the current self-discharge loss capacity and the remaining capacity of the battery to be tested can be predicted, thereby realizing the prediction of the self-discharge loss capacity of a storage battery. When users use the battery to be tested for cell matching, the self-discharge loss capacity and the remaining capacity of the battery to be tested can be obtained, to guide the user's selection of the batteries, so as to prevent economic losses caused by excessive differences in the capacity or self-discharge degree of the cell matching, thereby improving user experience.

An embodiment of the present disclosure further provides a screening method for battery self-discharge. FIG. 8 is a schematic flowchart of a screening method for battery self-discharge provided by the embodiments of the present disclosure. Referring to FIG. 8, the screening method for battery self-discharge includes:
S401, determining self-discharge currents of batteries to be tested under a preset condition by using a current detection method for battery self-discharge.

Specifically, the current detection method for battery self-discharge may be any one of the current detection methods for battery self-discharge described in the foregoing embodiments.

S402, performing, according to a relative relationship between the self-discharge current and a self-discharge current threshold value under the preset condition, a first screening on the batteries to be tested, to screen out first qualified batteries with normal self-discharge.

Specifically, the self-discharge current threshold value under the preset condition may be set according to the preset condition, battery disassembly experiment data, and user requirements, so that the first qualified batteries screened out satisfy the self-discharge current and meet user requirements.

S403, during a storage process of the first qualified batteries, predicting current remaining capacities of the first qualified batteries by using a loss capacity prediction method for self-discharge.

Specifically, after the first qualified batteries are screened out and before users perform cell matching, storage is always required for a period of time. During the storage process of the first qualified batteries, the current remaining capacities of the first qualified batteries are predicted by using the loss capacity prediction method for self-discharge in any of the foregoing embodiments.

S404, at an end of the storage process, performing, according to a relative relationship between the remaining capacity and a standard capacity for cell matching, a second screening on the first qualified batteries, to screen out a second qualified battery of which the remaining capacity satisfies cell matching requirements.

Specifically, the standard capacity for cell matching refers to a lower limit or range of a remaining capacity required by the user for the battery pack, which is a preset value and can be determined according to user requirements and/or disassembling experimental data. If the first qualified battery exceeds the standard capacity for cell matching, it indicates that the self-discharge degree of the first qualified battery during storage exceeds the standard, and the first qualified battery is not suitable for participating in the current cell matching. If the first qualified battery is above or within the standard capacity for cell matching, it indicates that the self-discharge degree of the first qualified battery during storage is within the normal range, and the first qualified battery can be added to the current cell matching and is a true qualified battery of the current cell matching.

The screening method for battery self-discharge provided by the embodiments uses the current detection method for battery self-discharge to determine the self-discharge currents of batteries to be tested under a preset condition; performs, according to a relative relationship between the self-discharge current and a self-discharge current threshold value under the preset condition, a first screening on the batteries to be tested, so as to screen out first qualified batteries with normal self-discharge; during the storage of the first qualified batteries, using the loss capacity prediction method for self-discharge to predict current remaining capacities of the first qualified batteries; at the end of the storage, performs, according to a relative relationship between the remaining capacity and a standard capacity for cell matching, a second screening on the first qualified batteries, so as to screen out a second qualified battery of which the remaining capacity satisfies cell matching requirements, thereby realizing two screening on the battery, so that a self-discharge degree of the screened battery is fully qualified, which is more suitable for user's cell matching, and improves the reliability of self-discharge screening.

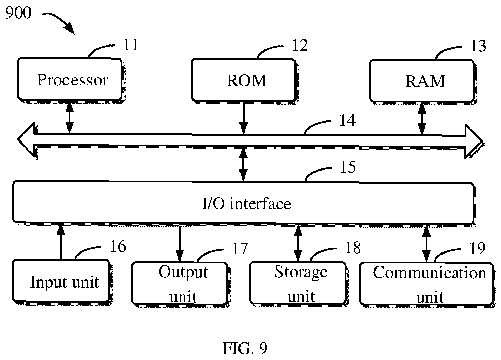

The embodiments of the present disclosure further provides an electronic device. FIG. 9 is a schematic diagram of a composition of an electronic device provided by embodiments of the present disclosure. Referring to FIG. 9, the electronic device 900 includes at least one processor 11 and a memory connected to the at least one processor 11 for communication, such as a read only memory (ROM) 12, a random access memory (RAM) 13, etc., where the memory stores a computer program executable by at least one processor. The processor 11 can perform various appropriate actions and processes according to the computer program stored in the read only memory (ROM) 12 or the computer program loaded from storage unit 18 into the random access memory (RAM) 13. In the RAM 13, various programs and data necessary for the operation of the electronic device 90 may also be stored. The processor 11, the ROM 12, and the RAM 13 are connected to each other through a bus 14. An input/output (I/O) interface 15 is also connected to the bus 14.

Multiple components in the electronic device 900 are connected to the I/O interface 15, which include: an input unit 16, such as a keyboard, a mouse, etc.; an output unit 17, such as various types of displays, speakers, etc.; a storage unit 18, such as a magnetic disk, an optical disk, etc.; and a communication unit 19, such as a network card, a modem, a wireless communication transceiver, etc. The communication unit 19 allows the electronic device 900 to exchange information/data with other devices through a computer network such as the Internet and/or various telecommunication networks.

The processor 11 may be a variety of general and/or special processing components having processing and computing capabilities. Some examples of the processor 11 include, but are not limited to, a central processing unit (CPU), a graphics processing unit (GPU), a variety of dedicated artificial intelligence (AI) computing chips, a variety of processors running machine learning model algorithms, digital signal processors (DSPs), as well as any appropriate processors, controllers, microcontrollers, etc. The processor 11 performs each of the methods and processes described above, for example, at least one of the current detection method for battery self-discharge, the loss capacity prediction method for battery self-discharge, and the screening method for battery self-discharge provided by the present disclosure.

Embodiments of the present disclosure further provide a computer-readable storage medium. The computer-readable storage medium stores computer instructions. The computer instructions are configured to enable a processor to implement at least one of the current detection method, the loss capacity prediction method, and the screening method for battery self-discharge in the present disclosure when executed.

It should be noted that the computer-readable storage medium may be non-volatile or volatile.

In some embodiments, at least one of the current detection method, the loss capacity prediction method, and the screening method for battery self-discharge may be implemented as a computer program tangibly embodied on a computer-readable storage medium, such as the memory unit 18. In some embodiments, part or all of the computer program may be loaded into and/or installed onto the electronic device 900 via the ROM 12 and/or the communication unit 19. When the computer program is loaded into the RAM 13 and executed by the processor 11, one or more actions of at least one of the current detection method for battery self-discharge, the loss capacity prediction method for battery self-discharge, and the screening method for battery self-discharge described above may be performed. Alternatively, in other embodiments, the processor 11 may be configured in any other suitable manner (for example, by means of firmware) to perform at least one of the current detection method for battery self-discharge, the loss capacity prediction method for battery self-discharge, and the screening method for battery self-discharge provided by the present disclosure.

Various embodiments of the systems and techniques described above herein may be implemented in digital electronic circuit systems, integrated circuit systems, field programmable gate arrays (FPGAs), application specific integrated circuits (ASICs), application specific standard products (ASSPs), system on chips (SOCs), load programmable logic devices (CPLDs), computer hardware, firmware, software, and/or combinations thereof. These various embodiments may include implementation in one or more computer programs that are executable and/or interpretable on a programmable system including at least one programmable processor. The programmable processor may be a special-purpose or a general-purpose programmable processor, and may receive data and instructions from a storage system, at least one input device, and at least one output device, and transmit data and instructions to the storage system, the at least one input device, and the at least one output device.

Computer programs for implementing the methods of the present disclosure may be written in any combination of one or more programming languages. These computer programs may be provided to a processor of a general-purpose computer, a special-purpose computer, or other programmable data processing apparatus, so that the computer programs, when executed by the processor, cause the functions/operations specified in the flowchart and/or block diagrams to be performed. The computer program may execute entirely on the machine, partly on the machine, as a stand-alone software package and partly on a machine and partly on a remote machine or entirely on the remote machine or server.

In the context of the present disclosure, a computer readable storage medium may be tangible media that may contain or store a computer program for use by or in connection with an instruction execution system, apparatus, or device. A computer-readable storage medium may include, but is not limited to, an electronic, magnetic, optical, electromagnetic, infrared, or semiconductor system, apparatus, or device, or any suitable combination of the foregoing. Alternatively, the computer-readable storage medium may be a machine-readable signal medium. More specific examples of the machine-readable storage medium would include electrical connections based on one or more wires, a portable computer disk, a hard disk, a random access memory (RAM), a read-only memory (ROM), an erasable programmable read-only memory (EPROM or flash memory), an optical fiber, a portable compact disc read-only memory (CD-ROM), an optical storage device, a magnetic storage device, or any suitable combination of the foregoing.

To provide interaction with a user, the systems and techniques described herein may be implemented on an electronic device having a display device (e. g., a CRT (cathode ray tube) or LCD (liquid crystal display) monitor) for displaying information to the user; and a keyboard and a pointing device (e. g., a mouse or a trackball) through which a user can provide input to the electronic device. Other types of devices may also be used to provide interaction with a user; for example, feedback provided to the user may be any form of sensory feedback (e. g., visual feedback, auditory feedback, or tactile feedback); and may receive input from the user in any form, including acoustic input, voice input, or tactile input.

The systems and technologies described herein may be implemented in a computing system that includes a backend component (e. g., as a data server), or that includes a middleware component (e. g., an application server), or that includes a front-end component (e. g., a user computer having a graphical user interface or a web browser, through which a user can interact with implementations of the systems and technologies described herein), or that includes any combination of such backend components, middleware components, or front-end components. The components of the system can be interconnected by any form or medium of digital data communication, such as a communication network. Examples of communication networks include local area networks (LANs), wide area networks (WANs), block chain networks, and the Internet.

A computing system may include clients and servers. The clients and servers are generally remote from each other and typically interact through a communication network. The client and server relationships are generated by computer programs running on the respective computers and having a client-server relationship to each other. The server may be a cloud server, also known as a cloud computing server or a cloud host, which is a host product in a cloud computing service system, so as to solve the defects of great management difficulty and poor service expansibility in traditional physical hosts and VPS services.

## Claims

1. A current detection method for battery self-discharge, comprising:
charging, under a preset condition, a battery by using a regulated power supply;
adjusting, during a charging process, a charging current provided by the regulated power supply until a voltage of the battery remains stable;
when the voltage of the battery remains stable, determining the charging current as a self-discharge current of the battery under the preset condition.

2. The current detection method for battery self-discharge according to claim 1, wherein the adjustment comprises gradually increasing a current value or gradually decreasing a current value.

3. A loss capacity prediction method for battery self-discharge, comprising:
obtaining experimental data of an experimental battery in a self-discharge current detection by using the current detection method for battery self-discharge of claim 1 or 2;
determining, based on an Arrhenius formula combined with the experimental data, a first relational expression of a self-discharge loss capacity of a battery to be tested and static condition data; wherein a material system of the battery to be tested is consistent with that of the experimental battery;
recording, during a storage process of the battery to be tested, measured values of static condition data of the battery to be tested; and
predicting, based on the measured values and the first relational expression, a current self-discharge loss capacity and a current remaining capacity of the battery to be tested.

4. The loss capacity prediction method for battery self-discharge according to claim 3, wherein the experimental data comprises a first experimental parameter and a second experimental parameter; wherein the first experimental parameter comprises different static durations and their corresponding self-discharge currents; the second experimental parameter comprises different static temperatures and their corresponding self-discharge currents;
wherein the determining, based on an Arrhenius formula combined with the experimental data, a first relational expression of a self-discharge loss capacity of a battery to be tested and static condition data, comprising:
determining a second relational expression of the self-discharge current and the static temperature according to a relationship between a self-discharge reaction rate constant and the self-discharge current as well as the Arrhenius formula;
determining a third relational expression of the self-discharge current and the preset duration according to the first experimental parameter;
determining a primary expression of the first relational expression according to a relationship between the self-discharge loss capacity and the self-discharge current, in combination with the second relational expression and the third relational expression;
substituting the second experimental parameter into the second relational expression to determine activation energy of the battery to be tested; and
substituting the first experimental parameter, the second experimental parameter and the activation energy into the primary expression to determine the first relational expression of the self-discharge loss capacity of the battery to be tested and the static condition data.

5. The loss capacity prediction method for battery self-discharge according to claim 3, wherein the static condition data comprise a static temperature and a static duration;
wherein the recording, during a storage process of the battery to be tested, measured values of static condition data of the battery to be tested, comprising:
recording an initial time when storage of the battery to be tested starts;
recording, during the storage process of the battery to be tested, the static temperature of the battery to be tested at every preset time interval;
during the storage process of the battery to be tested, recording a current time; and
calculating the static duration according to the current time and the initial time.

6. The loss capacity prediction method for battery self-discharge according to claim 4, wherein the substituting the second experimental parameter into the second relational expression to determine activation energy of the battery to be tested, comprises:
performing logarithmic transformation on the second relational expression;
substituting the second experimental parameter into the second relational expression after the logarithmic transformation, to determine the activation energy of the battery to be tested.

7. The loss capacity prediction method for battery self-discharge according to claim 4, wherein the predicting, based on the measurement values and the first relational expression, a current self-discharge loss capacity and a current remaining capacity of the battery to be tested, comprises:
calculating an average static temperature during the storage process according to all the static temperatures during the storage process;
determining the current self-discharge loss capacity of the battery to be tested by substituting the static duration and the average static temperature into the first relational expression; and
determining the current remaining capacity of the battery to be tested according to a difference value between an initial capacity when storage of the battery to be tested starts and the self-discharge loss capacity.

8. A screening method for battery self-discharge, comprising:
determining self-discharge currents of batteries to be tested under a preset condition by using the current detection method for battery self-discharge of claim 1 or 2;
performing, according to a relative relationship between the self-discharge current and a self-discharge current threshold value under the preset condition, a first screening on the batteries to be tested, to screen out first qualified batteries with normal self-discharge;
during a storage process of the first qualified batteries, predicting current remaining capacities of the first qualified batteries by using the loss capacity prediction method for self-discharge of any one of claims 3 to 7; and
at an end of the storage process, performing, according to a relative relationship between the remaining capacity and a standard capacity for cell matching, a second screening on the first qualified batteries, to screen out a second qualified battery of which the remaining capacity satisfies cell matching requirements.

9. An electronic device comprising:
at least one processor; and
a memory communicatively coupled to the at least one processor; wherein,
the memory stores a computer program executable by the at least one processor, wherein the computer program, when executed by the at least one processor, cause the at least one processor to perform the method of any one of claims 1 to 8.

10. A computer-readable storage medium storing computer instructions, wherein the computer instructions, when executed by a processor, are configured to implement the method of any one of claims 1 to 8.
